# EUROPEAN PATENT APPLICATION

(11) **EP 0 609 884 A1**
(43) Date of publication of application: **10.08.1994**
(21) Application number: 94101658.6
(22) Date of filing: 03.02.1994
(51) Int. Cl.: H01L 31/107

(54) **Semiconductor light receiving device**

(30) Priority: 04.02.1993 JP 16662/93
(71) Applicant: NEC CORPORATION, Tokyo (JP)
(72) Inventor: Watanabe, Isao, c/o NEC Corporation, Minato-ku, Tokyo (JP)
(74) Representative: Glawe, Delfs, Moll & Partner

(57) **Abstract**

A semiconductor light receiving device is a mesa type pn junction photodiode, in which a high resistance or semi-insulation semiconductor layer is provided on the side surfaces of a mesa to lower surface leakage dark current and enhance reliability.

## Description

### FIELD OF THE INVENTION

This invention relates to a semiconductor light receiving device, and more particularly to , an avalanche photodiode operating with low dark current and high reliability.

### BACKGROUND OF THE INVENTION

In order to provide a optical communication system operating with high speed, high sensitivity and high reliability, semiconductor light receiving devices having high speed response, low dark current property and high reliability are required. For this purpose, avalanche photodiodes and pin photodiodes of InP/InGaAs system which can be adapted to silica system optical fibers having a low loss wavelength band of 1.3 to 1.6µm have been recently researched and developed. In the InP/InGaAs system avalanche photodiodes, devices having properties such as a low capacitance realized by reducing the diameter of detecting area, the decrease of carrier transit time realized by optimizing the thickness of semiconductor layers, the suppression of carrier trap realized by the provision of an intermediate layer at a hetero-interface, a gain bandwidth product of approximately 80GHz, and high speed and high reliability of approximately 8GHz at the maximum band have been practically used.

In such devices, however, a ratio α/β of ionization rate (α:ionization rate of electrons, and β: that of holes) for InP which is an avalanche multiplication layer is small. For this reason, the gain bandwidth product is difficult to be greater than 80 to 100Ghz at the maximum value, and the excess noise index X becomes as large as 0.7 inversely proportional to the ratio α/β, so that limitation occurs in regard to high speed, low noise and high sensitivity. The same results are obtained even in the case where other bulk semiconductors such as III-V group compound semiconductors are used for an avalanche multiplication layer. In this situation, the ratio α/β is required to be artificially increased, so that high gain bandwidth product (high speed response) and low noise operation are realized.

For this reason, a device structure in which the ratio α/β is artificially increased by utilizing conduction band-edge discontinuity ΔEc in superlattice for impact ionization of electrons has been described on pages 38 to 40 of "Appl. Phys. Lett. Vol. 40(1), 1982", as proposed by F. Cappaso, et al. Actually, it is confirmed that the ratio α/β is increased by using GaAs/GaAlAs system superlattice, wherein the ratio α/β is less than 2 by using bulk GaAs, while it is increased to 8 by using superlattice.

A similar device structure for which InGaAsP/InAlAs system superlattice having light receiving sensitivity at a wavelength band of 1.3 to 1.6µm to be used for long distance optical communication is used has been described on pages 1419 to 1423 of "J. Quantum Electron, vol. 28(6), 1992", as proposed by Kagawa, et al. The proposed device is defined "a first conventional semiconductor light receiving device" hereinafter. In this first conventional semiconductor light receiving device, the ratio α/β is increased to 10, and low noise operation is realized in accordance with the increase of the ratio α/β.

In the first conventional semiconductor light receiving device, however, there are disadvantages in that dark current is increased, and the reliability is lowered in accordance with the increase of the dark current. The device structure and the reasons for the disadvantages will be explained later.

On the other hand, another device structure in which a polyimide film is used for a mesa passivation film has been described on pages 261 to 264 of "European Conference on Optical Communication, TuC 5-4, 1991", as proposed by Nakamura, et al. The proposed device is defined "a second conventional semiconductor light receiving device" hereinafter. In the second conventional semiconductor light receiving device, the same disadvantages as in the first conventional semiconductor light receiving device are observed. The device structure and the reasons for the disadvantages will be explained.

### SUMMARY OF THE INVENTION

Accordingly, it is an object of the invention to provide a semiconductor light receiving device in which surface leakage current is decreased.

It is a further object of the invention to provide a semiconductor light receiving device in which dark current is decreased.

It is a still further object of the invention to provide a semiconductor light receiving device having high reliability.

According to the invention, a semiconductor light receiving device, comprises:
a semiconductor layer of a high resistance provided on side surfaces of a mesa, the semiconductor layer being lattice-matched to a semiconductor substrate.

Where the substrate is InP, InAlAs is used as the high resistance semiconductor layer, and Fe doped InP is used as the semi-insulating semiconductor layer.

### BRIEF DESCRIPTION OF THE DRAWINGS

The invention will be explained in more detailed in conjunction with appended drawings, wherein:
Fig. 1 is a schematic view showing a first conventional semiconductor light receiving device;
Fig. 2 is a schematic view showing a second conventional semiconductor light receiving device; and
Fig. 3 is a schematic view showing a semiconductor light receiving device in a preferred embodiment according to the invention.

### DESCRIPTION OF THE PREFERRED EMBODIMENTS

Before explaining a semiconductor light receiving device in the preferred embodiment according to the invention, the aforementioned conventional semiconductor light receiving devices will be explained.

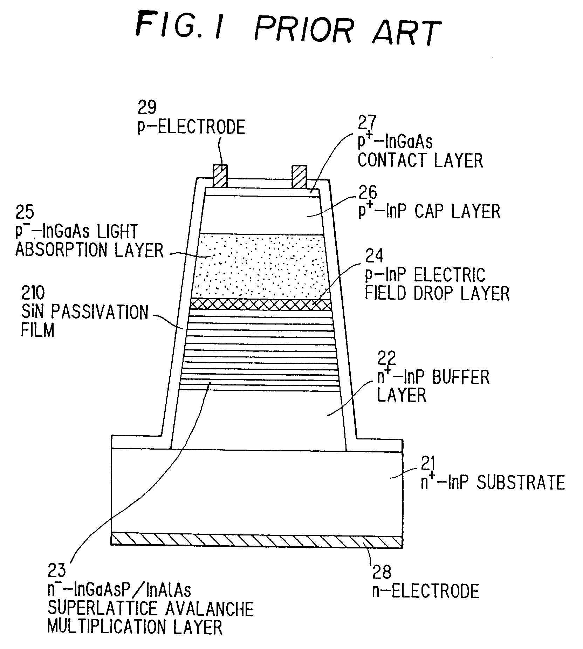

Fig. 1 shows the first conventional semiconductor light receiving device which comprises a n⁺-InP substrate 21, a n⁺-InP buffer layer 22, a n⁻-InGaAsP/InAlAs superlattice avalanche multiplication layer 23, a p-InP electric field drop layer 24, a p⁻-InGaAs light absorbing layer 25, a p⁺-InP cap layer 26, a p⁺-InGaAs contact layer 27, a n-electrode 28, a p-electrode 29, and a SiN passivation film 210.

In the superlattice structure of the first conventional semiconductor light receiving device, a conduction band-edge discontinuity ΔEc which is 0.39eV is greater than the valence band-edge discontinuity ΔEv which is 0.03eV, so that energy obtained by electrons entering into well layers is greater than that obtained by holes entering into the well layers. Consequently, the electrons are easier to reach an ionization threshold value energy than holes, thereby increasing the ionization rate of electrons. Thus, a ratio α/β of ionization rates is increased to realize low noise operation.

In the first conventional semiconductor receiving device, however, there are disadvantages in that leak current flows in accordance with interface level at interfaces of the semiconductor layers 23,24 and 25 relative to the passivation film 210, residual oxidation films of the semiconductor layers, and defects thereof, and that the dark current is increased to the order of 0.8 to several µA at a practical multiplication rate of 10 to 20. In accordance with this dark current, noise is increased to negate the advantage of low noise operation realized by the improvement of the ratio of ionization rate.

Further, this passivation interface is unstable for a long time usage under the condition of a general reliability test such as atmospheric temperature of 200°C, reverse bias current of 100µA etc. Thus, the reliability for device properties is not sufficient due to the increase of dark current.

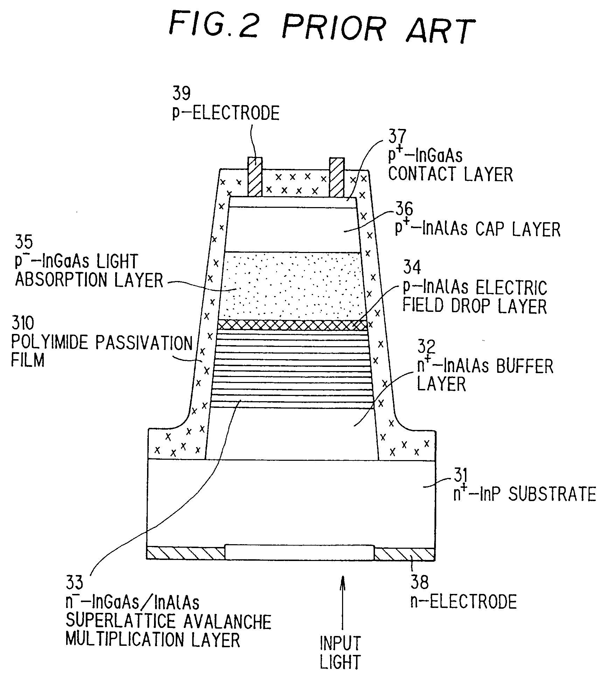

Fig. 2 shows the second conventional semiconductor light receiving device which comprises a n⁺-InP substrate 31, a n⁺-InAlAs buffer layer 32, a n⁻-InGaAs/InAlAs superlattice avalanche multiplication layer 33, a p-InAlAs electric field drop layer 34, a p⁻ -InGaAs light absorbing layer 35, a p⁺-InAlAs cap layer 36, a p⁺-InGaAs contact layer 37, a n-electrode 38, a p-electrode 39, a polyimide passivation film 310, and an anti-reflection film 311.

Even in the semiconductor light receiving device using the polyimide passivation film 310, the same disadvantages as in the first conventional semiconductor light receiving device are absorbed in regard to leak dark current and reliability caused by the same reasons in the first conventional semiconductor light receiving device.

Next, a semiconductor light receiving device in the preferred embodiment according to the invention will be explained.

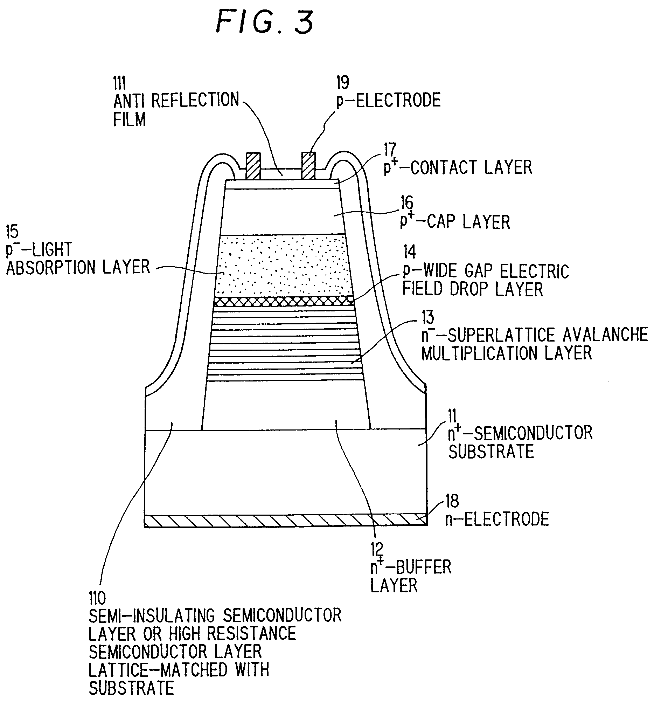

Fig. 3 shows the preferred semiconductor light receiving device which comprises a n⁺-semiconductor substrate 11, a n⁺-buffer layer 12, a n⁻-superlattice avalanche multiplication layer 13, a p-widegap electric field drop layer 14, a p⁻-light absorption layer 15, a p⁺-cap layer 16, a p⁺-contact layer 17, a n-electrode 18, a p-electrode 19, a semi-insulating or high resistance semiconductor layer 110 which is lattice-matched to the substrate 11, and an anti-reflection film 111.

The semiconductor light receiving device will be fabricated by using an InAlAs/InAlGaAs superlattice avalanche multiplication layer lattice-matched with an InP substrate, as set out below.

On a n⁺-InP substrate 11, a n⁺-InP buffer layer 12 having a thickness of 0.5µm, a n⁻-InAlGaAs/InAlAs superlattice multiplication layer 13 having a carrier concentration of less than or equal to 2 x 10¹⁵cm⁻³ and a thickness of 0.23µm, a p⁺-InP electric field drop layer 14 having a carrier concentration of less than or equal to 2 x 10¹⁸cm⁻³ and a thickness of 0.05µm, a p⁻-InGaAs light absorption layer 15 having a carrier concentration of less than or equal to 8 x 10¹⁵cm⁻³ and a thickness of 1µm, a p⁺-cap layer 16 having a carrier concentration of larger than or equal to 1 x 10¹⁸cm⁻³ and a thickness of 0.5µm, and a p⁺-InGaAs contact layer 17 having a carrier concentration of larger than or equal to 1 x 10¹⁹cm⁻³ and a thickness of 0.1µm are successively grown by using gas source molecular beam epitaxy (gas source MBE).

Next, a circular mesa is formed for the above fabricated layers by using ordinary photolithography and wet etching. Then, a high resistance InAlAs layer 110 is recrystalline grown on the wafer thus prepared by using the gas source MBE. Prior to the recrystalline growth of the layer 110, natural oxidation film is removed on the surface of the wafer in a growth chamber by heating the substrate 11, using hydrogen radical beam cleaning process, etc. Un doped InAlAs (lattice-matched with InP) obtained by MBE is usually of a high resistance. Therefore, the layer structure as described above is relatively easy to be fabricated.

On the surface of the wafer thus obtained, an anti-reflection film 111 of SiN film is formed, and a p-electrode 19 of AuZn is provided to contact via the anti-reflection film 111 the p⁺-InGaAs contact layer 17.

Finally, the back surface of the substrate 11 is polished to be provided with a n-electrode 18 of AuGeNi.

In the first and second conventional semiconductor light receiving device as shown in Figs. 1 and 2, a great number of interface levels (more than 2 x 10¹²cm⁻²/eV) exist at an interface between the SiN film 210 or the polyimide film 310 and the mesa side wall. The interface levels are caused by dangling bond at an interface between the SiN film or the polyimide film and the semiconductor, dangling bond at an interface between semiconductor natural oxidation film generated after the mesa formation and the semiconductor, defects on the surface, etc. Especially, the dangling bond exists dominantly in the p⁻-InGaAs light absorption layer 25 or 35 having a relatively small bandgap energy among the semiconductor layers 23 to 25 or 33 to 35 depleted at the time of reverse bias, and the natural oxidation film exists dominantly in the superlattice multiplication layer 23 or 33 including Al atoms to be easily oxidized thereamong. Consequently, surface leak dark current flowing via the interface levels is never avoided at the time of reverse bias, and this current is increased to the order of µA under a high electric field to expect a practical field to expect a practical multiplication rate. Further, the deterioration of dark current occurs due to the increase of interface levels, surface defects, etc. caused by long term usage. This leads to low reliability.

In the semiconductor light receiving device in the preferred embodiment as shown in Fig. 3, however, the dangling bond causing the interface levels, the surface defects, etc. is terminated by the semiconductor passivation film which is lattice-matched with the substrate, so that the interface levels, the surface defects, etc. are remarkably decreased. Further, when the semiconductor passivation film is recrystalline-grown on the mesa side surfaces, having the substrate or radiating hydrogen radical beams is carried out in the MBE method, so that it is possible to remove natural oxidation films generated on the mesa side surfaces. Consequently, the dangling is decreased at the semiconductor natural oxidation film/semiconductor interface. In this case, when the passivation film is highly resistive or semi-insulating semiconductor, leak current is suppressed to be less than several ten nA under an electric field of less than on tunneling breakdown voltage or avalanche breakdown voltage, even if a bias voltage is applied across the passivation film.

As understood from the above explanations, surface leakage dark current is decreased in the invention as compared to the first and second conventional semiconductor light receiving device. Further, the time-elapse increase of interface levels and interface defects is significantly suppressed to increase the reliability of the semiconductor light receiving device in the invention.

Although the invention has been described with respect to specific embodiment for complete and clear disclosure, the appended claims are not to be thus limited but are to be construed as embodying all modification and alternative constructions that may be occur to one skilled in the art which fairly fall within the basic teaching here is set forth.

## Claims

1. In a semiconductor light receiving device of a mesa type pn junction photodiode, said semiconductor light receiving device, comprising:
a semiconductor layer of a high resistance provided on side surfaces of a mesa, said semiconductor layer being lattice-matched to a semiconductor substrate.

2. In a semiconductor light receiving device of a mesa type pn junction photodiode, according to claim 1,
said semiconductor substrate is InP, and said semiconductor layer is InAlAs which is lattice-matched to InP.

3. In a semiconductor light receiving device of a mesa type pn junction photodiode, said semiconductor light receiving device, comprising:
a semiconductor layer of a semi-insulating provided on side surfaces of a mesa, said semiconductor layer being lattice-matched to a semiconductor substrate.

4. In a semiconductor light receiving device of a mesa type pn junction photodiode, according to claim 3,
said semiconductor substrate is InP, and said semiconductor layer is Fe doped InP which is lattice-matched to InP.
